(19) Europäisches Patentamt

European Patent Office

Office européen des brevets

(11) EP 0 390 593 B1

# (12) EUROPEAN PATENT SPECIFICATION

(45) Date of publication and mention
of the grant of the patent:
**02.10.1996 Bulletin 1996/40**

(51) Int Cl.6: **H03F 3/45**, H03F 1/22,
H03K 19/086, H01L 27/06,
H01L 27/07

(21) Application number: **90303447.8**

(22) Date of filing: **30.03.1990**

(54) **Heterojunction bipolar transistor integrated circuit**

Integrierter Schaltkreis aus bipolaren Transistoren mit Heteroübergang

Circuit intégré de transistors bipolaires à hétérojonction

(84) Designated Contracting States:
**DE FR GB**

(30) Priority: **30.03.1989 JP 79401/89**

(43) Date of publication of application:
**03.10.1990 Bulletin 1990/40**

(73) Proprietor: **KABUSHIKI KAISHA TOSHIBA**
**Kawasaki-shi, Kanagawa-ken 210 (JP)**

(72) Inventor: **Akagi, Junko,**
**c/o Intellectual Property Division**
**Tokyo (JP)**

(74) Representative: **Freed, Arthur Woolf et al**
**MARKS & CLERK,**
**57-60 Lincoln's Inn Fields**
**London WC2A 3LS (GB)**

(56) References cited:
**US-A- 4 121 169**

- **ELECTRONICS LETTERS. vol. 24, no. 18, 1 September 1988, ENAGE GB pages 1178 - 1179; H. NAKAJIMA ET AL: 'WIDEBAND DIRECT-COUPLED DIFFERENTIAL AMPLIFIERS UTILISING ALGAAS/GAAS HBT'S'**
- **PATENT ABSTRACTS OF JAPAN vol. 9, no. 266 (E-352)23 October 1985 & JP-A-60 113 525**
- **IEEE PROCEEDINGS E. COMPUTERS & DIGITAL TECHNIQUES. vol. 132, no.2, March 1985, STEVENAGE GB pages 62 - 67; A. STEVENSON ET AL: "PROPRIETARY SEMICUSTOM REGENERATOR IC FOR 140 MBIT/S OPTICAL TRANSMISSION SYSTEMS"**

## Description

This invention relates to a heterojunction bipolar transistor integrated circuit, and more particularly to a high-speed heterojunction bipolar transistor integrated circuit.

Heretofore a bipolar transistor having a hetero-emitter construction for improving the high-speed operability has been widely known.

A heterojunction bipolar transistor having junction of different kinds of semiconductors materials exhibits various merits in comparison with a homojunction bipolar transistor having junctions of the same kind of semiconductor materials.

One of the merits resides in that, even with a small impurity density ratio between the emitter region and the base region, the emitter injection efficiency can be improved by utilizing the difference in the band gap. As a result, the impurity density in the base layer can be increased so as to reduce the base resistance, and furthermore the accumulating effect of minority carriers can be reduced as well as the base layer can be made thin. According to another merit, the impurity density of the emitter layer can be reduced, thereby reducing the emitter junction capacitance. Therefore, the cut-off frequency $f_T$ of the heterojunction bipolar transistor is made extremely high.

Because of the above described merits, the heterojunction bipolar transistor exceeds the conventional homojunction bipolar transistor in both of the high-frequency characteristics and the switching characteristics, and wide application thereof is expected in the fields of microwave transistor, high-speed logic circuit transistor and a high-speed analog integrated circuit transistor.

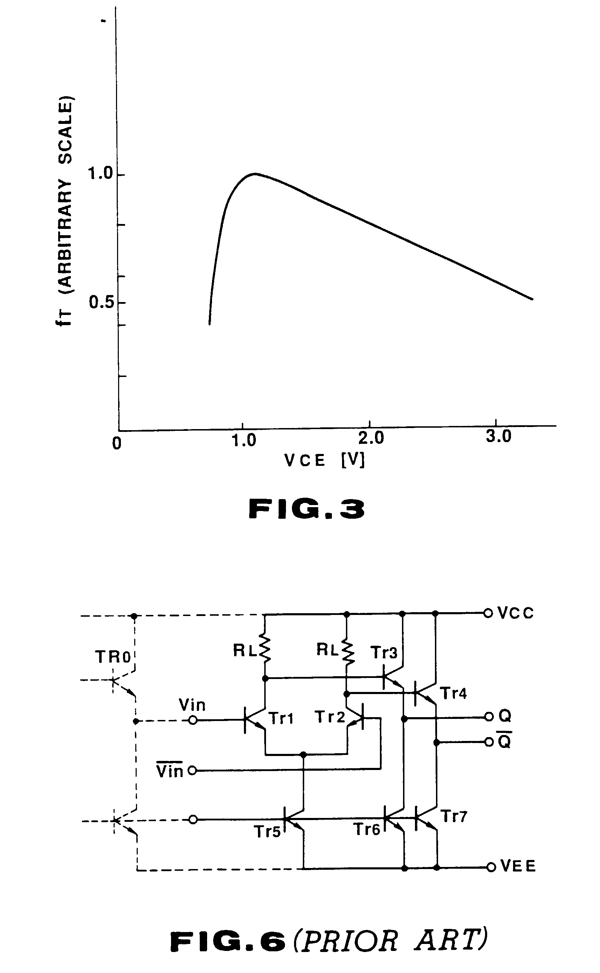

However, as is seen from the results of the measurement with respect to the collector-emitter voltage $V_{CE}$ vs. the cut-off frequency $f_T$ shown in Fig. 3, the cut-off frequency $f_T$ of the heterojunction bipolar transistor highly depends on the collector-emitter voltage $V_{CE}$, and it has been widely known that the cut-off frequency $f_T$ of the heterojunction bipolar transistor is reduced in accordance with an increase in the collector-emitter voltage $V_{CE}$. Therefore, the biasing condition for the heterojunction bipolar transistor greatly affects the circuit characteristics.

Heretofore, a circuit construction including an emitter coupled logic circuit (ECL) as shown in Fig. 6 is widely known as an example of integrated circuit utilizing the heterojunction bipolar transistor. The ECL circuit is constructed with a differential transistor pair formed by first and second heterojunction bipolar transistors $T_{r1}$ and $T_{r2}$, and the collector outputs of the transistors $T_{r1}$ and $T_{r2}$ are connected to outputs Q, $\overline{Q}$, through emitter follower transistors $T_{r3}$ and $T_{r4}$. Transistors $T_{r5}$, $T_{r6}$ and $T_{r7}$ operate as constant current circuits. A reference character RL designates a load resistance, and reference characters $V_{cc}$ and $V_{EE}$ designate power supply voltages. In the ECL circuit shown in Fig. 6, a voltage $V_{in}$ applied to the first and second heterojunction bipolar transistors $T_{r1}$ and $T_{r2}$ is ordinarily obtained from a transistor $T_{r0}$ of a preceding circuit, which operates as emitter follower. When it is assumed that turn-on voltages of the transistors $T_{r0}$, $T_{r1}$ and $T_{r2}$ are $V_o$ and the logic amplitudes of these transistors are $V_{LS}$, the following relation will be composed:

$$V_{on} \leqq V_{cc} - V_{in} \leqq V_{on} + V_{LS}$$

Since the turn-on voltage of a typical heterojunction bipolar transistor, for instance, a GaAs / AℓGaAS (gallium-arsenide / aluminum-gallium-arsenide) heterojunction bipolar transistor is approximately 1.5V, the collector-emitter voltage $V_{CE}$ of the first and second heterojunction bipolar transistors $T_{r1}$ and $T_{r2}$ falls between the sum of the turn-on voltage of the transistor $T_{r0}$ operable as emitter follower of the preceding stage and the turn-on voltage of the bipolar transistors $T_{r1}$ and $T_{r2}$, and a value obtained by adding the logic amplitude $V_{LS}$ to the sum, that is between 3V and 3V + $V_{LS}$ V. As is apparent from the cut-off frequency ($f_T$) characteristics curve shown in Fig. 3, the ECL circuit operates in a region having a comparatively low cut-off frequency $f_T$, more specifically in a region having approximately 60% of the maximum cut-off frequency of the transistors.

As described above, in a circuit such as the ECL circuit where the transistors are operated in a comparatively high collector-emitter voltage region, the cut-off frequency thereof is greatly reduced by a small amount of variation of a the collector-emitter voltage $V_{CE}$ applied to the heterojunction bipolar transistors, and the inherent high cut-off frequency performance of the heterojunction bipolar transistors cannot be utilised effectively.

The use of a second pair of transistors connected to the differential amplification part of an ECL circuit is disclosed in Patent Abstracts of Japan, Vol. 9, No. 266 (E-352), 23 October 1985, JP-A-60-113525.

The use of HBTs in a difference amplifier is described in Electronic Letters, Vol. 24, No. 18, 1 September 1988, Stevenage, pages 1178-1179; H. Nakajima et al: "Wideband direct-coupled differential amplifiers utilising AlGaAs/GaAs HBTs".

A pair of cascode transistors used in an emitter-coupled difference amplifier is disclosed in IEE . Proceedings E. Computers Digital Techniques, Vol. 132, Pts. E and I, No. 2, March 1985, pages 62-67; A. Stevenson et al; "Proprietary semicustom re-generator IC for 140 Mbit/s optical transmission systems".

A cascode amplifier having a constant collector-emitter voltage is disclosed in US-A-4121169.

An object of the present invention is to provide an integrated circuit wherein the high cut-off frequency characteristics inherent in the heterojunction bipolar transistors is fully utilised and the high-speed and high-frequency operation characteristics of the integrated circuit are substantially improved.

Another object of the invention is to provide a circuit wherein the collector-emitter voltage can be reduced to an optimum value in a circuit in which the collector-emitter voltage is comparatively high, whereby the high cut-off frequency characteristics of the heterojunction bipolar transistors are exploited effectively.

According to the present invention there is provided a heterojunction bipolar transistor integrated circuit comprising:

first and second heterojunction bipolar transistors each comprising:
an emitter including a first semiconductor material,
a base including a second semiconductor material having a band gap narrower than that of the first semiconductor material, the base defining a pn junction with the emitter, and
a collector including one of the first semiconductor material and the second semiconductor material, the collector defining a pn junction with the base, the first and second heterojunction bipolar transistors constituting a differential transistor pair; and
third and fourth heterojunction bipolar transistors each comprising an emitter, a collector and a base, the emitters of the third and fourth heterojunction bipolar transistors being respectively coupled to the collectors of the first and second heterojunction bipolar transistors, the bases of the third and fourth heterojunction bipolar transistors being coupled to each other, wherein there is provided voltage supplying means for supplying a fixed voltage to the bases of the third and fourth heterojunction bipolar transistors, the fixed voltage having a value such that a collector-emitter voltage of the first and second heterojunction bipolar transistors has a value such that the cut-off frequency of the first and second heterojunction bipolar transistors is at least 80% of the maximum cut-off frequency of the first and second heterojunction bipolar transistors.

Therefore, according to the present invention, in an integrated circuit which includes heterojunction bipolar transistors, the emitter of a transistor with a base applied to a predetermined voltage $V_A$ is connected to the collector of each heterojunction bipolar transistor. The predetermined voltage is preferably determined to satisfy the following equation.

$$V_A = V_{in} + V_{CE0}$$

where $V_{in}$ represents input voltage, and $V_{CE0}$ represents a collector-emitter voltage for obtaining an optimum cut-off frequency.

With the above described construction, the collector-emitter voltage $V_{CE}$ of the heterojunction bipolar transistor has a constant value, and the cut-off frequency thereof can be maintained at a desired value. More specifically, by selecting the fixed value $V_A$ to be equal to $V_{in} + V_{CE0}$, the collector-emitter voltage $V_{CE}$ is approximately equal to

$$V_{CE} = V_A - V_{in} = (V_{in} + V_{CE0}) - V_{in} = V_{CE0}$$

As a result, the $V_{CE}$ value of the transistor is maintained an optimum value and the transistor has a high cut-off frequency. Since the bipolar transistors can be used in a range where the cut-off frequency is kept at an optimum value, the high-speed and high-frequency operation characteristics thereof can be obtained.

In the above description, an ECL circuit has been described as an example of a circuit having a comparatively high collector-emitter voltage. However, it is apparent that the invention is not restricted to the ECL circuit, but can be applied to various circuits wherein the heterojunction bipolar transistors are used.

In the accompanying drawings:

Fig. 1 is a circuit diagram showing a first embodiment of an ECL circuit forming a part of an integrated circuit according to this invention;
Fig. 2 is a sectional view showing an example of heterojunction bipolar transistors used in the ECL circuit;
Fig. 3 is a graph showing a relation between the collector-emitter voltage $V_{CE}$ and the cut-off frequency $f_T$ of the heterojunction bipolar transistors;
Fig. 4(a) is a circuit diagram showing a second embodiment of the ECL circuit according to this invention;
Figs. 4(b) and 4(c) are circuit diagrams to be substituted for the part A of the ECL circuit shown in Fig. 4(a), providing modifications of the second embodiment;
Fig. 5(a) is a circuit diagram showing a third embodiment of the ECL circuit according to this invention;
Fig. 5(b) is a circuit diagram to be inserted before $V_{in}$ and $\overline{V_{in}}$ of the ECL circuit shown in Fig. 5(a) providing a modification of the third embodiment; and
Fig. 6 is a circuit diagram showing a conventional example of the ECL circuit forming one part of an integrated circuit including the heterojunction bipolar transistors.

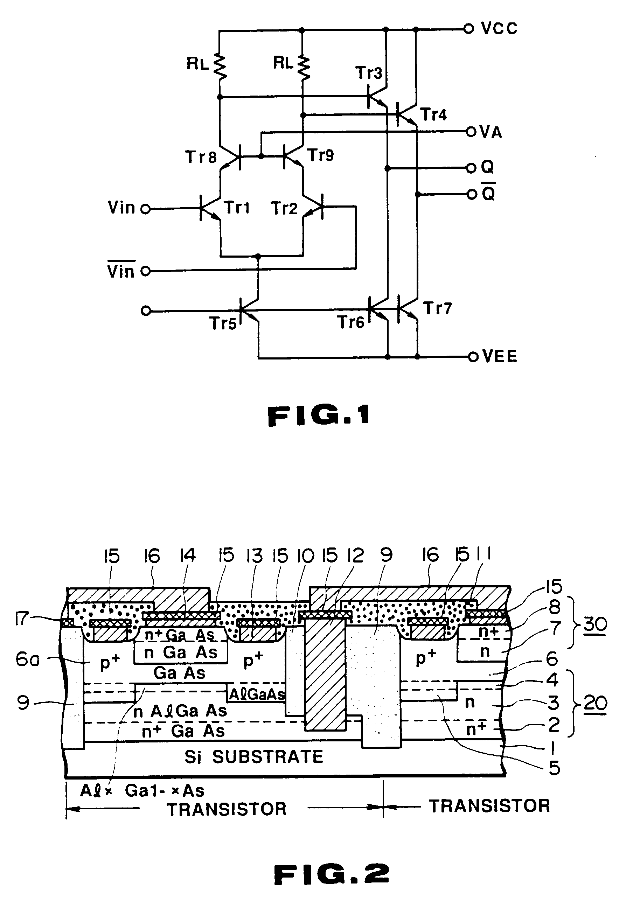

Fig. 1 is a circuit diagram showing an example of an ECL circuit formed according to the present invention. The ECL circuit is novel in that 8th and 9th transistors $T_{r8}$ and $T_{r9}$ having base voltages fixed to a value $V_A$ are inserted to be connected with the collectors fo first and second GaAs / AℓGaAs heterojunction bipolar transistors $T_{r1}$ and $T_{r2}$. Otherwise construction is quite similar to the conventional ECL circuit shown in Fig. 6.

More specifically, the heterojunction bipolar transistors $T_{r1}$ to $T_{r9}$ used in the integrated circuit are of collector-top type, as partly shown in Fig. 2 in which collector layers are placed at the top, and the collector 30 of the transistor $T_{r1}$ is connected to the emitter 20 of the transistor $T_{r8}$. The junction area between the base region and the emitter region is wider than the junction area between the base region and the collector region, and a contact for the base region is formed on a part of the junction area between the base region and the emitter region.

More in detail, on a semi-insulating GaAs substrate 1 are formed an $n^+$ type GaAs layer 2 of 5000 Å thickness and impurity (Si) density of $2 \times 10^{18}$ cm$^{-3}$; and n type Aℓ 0.3 Ga 0.7 As layer 3 of 3300 Å thickness and impurity (Si) density of $3 \times 10^{17}$ cm$^{-3}$; and an n type Aℓ$_x$ Ga$_{1-x}$ As$_s$ layer (forming a transition region) 4 of 200 Å thickness and impurity (Si) density of $3 \times 10^{17}$ cm$^{-3}$, the composition x of Aℓ being varied continuously or stepwisely from 0 to 0.3; all the layers being laminated in this order so as to form an n type emitter region 20. On the n type emitter region 20 is provided a P$^+$ type GaAs layer 6 having a thickness of 1000 Å with an impurity density held at $3 \times 10^{18}$ cm$^{-3}$ and operable as a heterojunction base region. On the layer 6 operable as a base region is provided a collector region 30 comprising an n type GaAs layer 7 having a thickness of 3500 Å and an impurity density of $1 \times 10^{17}$ cm$^{-3}$; and an n$^+$ GaAs layer 8 of a thickness 1000 Å and an impurity density $2 \times 10^{13}$ cm$^{-3}$ formed on the layer 7.

Furthermore, an outer base region 6a is formed by a selective ion-injection so as to provide a contact for the base region, and separating regions 9 and 10 are formed by selectively ion-injecting H, B or the like. Numeral 17 designates a load resistor formed by vacuum-depositing NiCr and the like on the element-separating region 9, numeral 11 designates an insulating film, numeral 12 an emitter electrode made of an AuGe layer and Au layer, numeral 13 a base electrode made of an AuZn layer, and numeral 14 designates a collector electrode made of an AuGe layer and an Au layer. These electrodes are connected through a first lead wire 15 and a second lead wire 16 both made of an Aℓ layer.

The ECL circuit of the above described construction operates as follows. Assuming that $V_{cc} > V_{EE}$, the collector voltage of the first and second heterojunction bipolar transistors $T_{r1}$ and $T_{r2}$ are made equal to $V_A - V_{on}$. On the other hand emitter voltages of the first and second bipolar transistors $T_{r1}$ and $T_{r2}$ are substantially made equal to $V_{in} - V_{on}$. Accordingly, the collector-emitter voltage $V_{CE}$ of the first and second transistors $T_{r1}$ and $T_{r2}$ is expressed to be:

$$(V_A - V_{on}) - (V_{in} - V_{on}) = V_A - V_{in}.$$

Thus when the base voltage of the 8th and 9th transistors $T_{r8}$ and $T_{r9}$ is fixed to a contact voltage $V_A = V_{in} + V_{CE0}$ (wherein $V_{CE0}$ is a collector-emitter voltage giving an optimum cut-off frequency). The collector-emitter voltage $V_{CE}$ of the first and second heterojunction bipolar transistors $T_{r1}$ and $T_{r2}$ is substantially made equal to

$$V_{CE} = V_A - V_{in} = (V_{in} + V_{CE0}) - V_{in} = V_{CE0}$$

so that the voltage $V_{CE}$ is maintained an optimum value where the cut-off frequency of the transistors is high.

In Fig. 3, the value $V_{CE0}$ is in a range from 0.8V to 2.0V. Accordingly, by setting the fixed voltage $V_A$ to a value higher than the input voltage $V_{in}$ by 0.8 to 2.0V, the collector-emitter voltage $V_{CE}$ of the first and second heterojunction bipolar transistors $T_{r1}$ and $T_{r2}$ is made equal to $V_{CE0}$, so that the cut-off frequency of the transistors $T_{r1}$ and $T_{r2}$ is maintained high value enabling to exhibit maximum capability of the circuit.

That is, in the ECL circuit of this invention, a cut-off frequency of approximately 1.7 times higher than that of the conventional ECL circuit can be realized. Furthermore, the collector voltage of the first and second heterojunction bipolar transistors $T_{r1}$ and $T_{r2}$ can be maintained at a constant value, and therefore the delay time caused by the charge and discharge of the transistors is utterly eliminated, so that a high-speed operation of the transistors is thereby made possible.

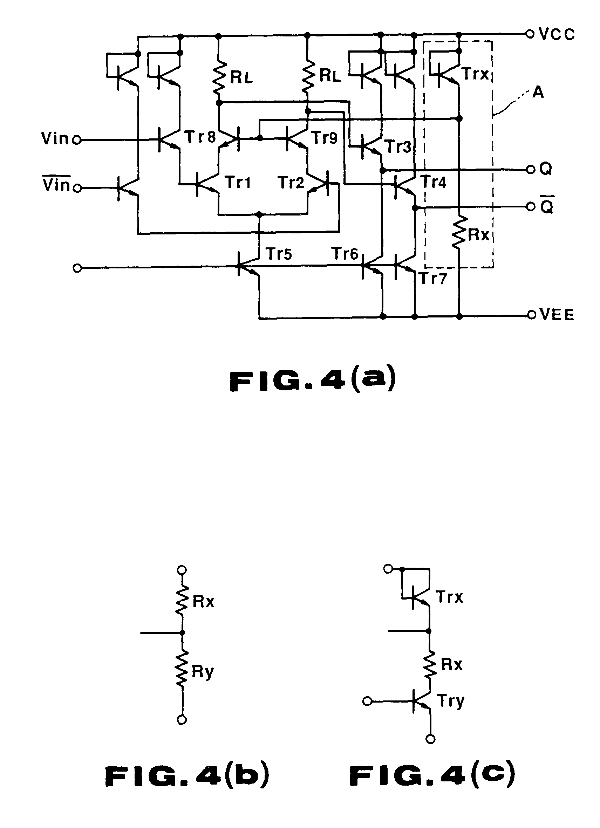

Fig. 4(a) shows a second embodiment of this invention in which a series circuit of a transistor Trx and a resistor Rx is inserted to the ECL circuit of Fig. 1 (portion A in Fig. 4(a)) to divide the voltage between $V_{CC}$ and $V_{EE}$. The connection point of the transistor Trx and the resistor Rx is connected to the bases of the transistors $T_{r8}$ and $T_{r9}$ so as to supply the divided voltage to the bases of the transistors $T_{r8}$ and $T_{r9}$. With this construction, the number of the external power supply can be reduced.

For the circuit to obtain the divided voltage, a series circuit of resistors Rx and Ry or transistors Trx, Try and a resistor Rx may also used as shown in Figs. 4(b) and 4(c), respectively. Incidentally, trnsistors in emitter follower configuration are inserted in the input stage in the second embodiment.

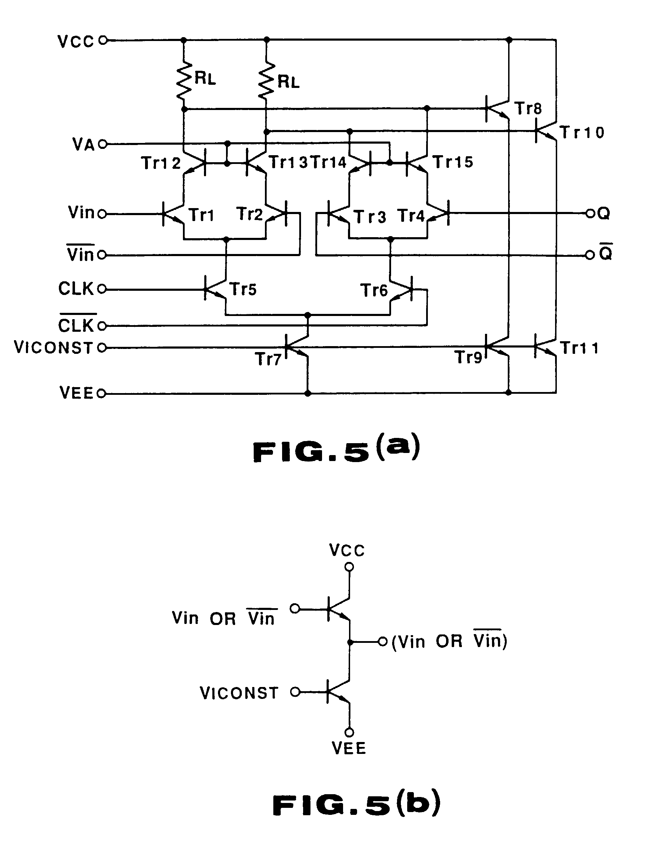

Fig. 5(a) shows a third embodiment of this invention suitable for an ECL latch circuit typically use as a flip-flop circuit. In this embodiment, the high speed operation can be ensured. A circuit shown in Fig. 5(b) may be inserted before $V_{in}$ and $V_{in}$ in Fig. 5(a).

In the foregoing embodiments, description is made with respect to a collector-top heterojunction bipolar transistor having a collector layer formed uppermost. However, the present invention is also applicable to a heterojunction bipolar transistor of emitter-top type in which its uppermost layer is an emitter layer.

Further, in the above described embodiments, it is described on a case wherein the base of the transistor is made of GaAs while the emitter of the same is made of AℓGaAS. However, the present invention is further applicable to a case where the base and emitter regions are formed by combinations of, for instance, InGaAs and InP, InAℓAs and InAℓAs, Ge and GaAs, Si and GaP, and the like.

**Claims**

1. A heterojunction bipolar transistor integrated circuit comprising:

    first and second heterojunction bipolar transistors (Tr1, Tr2) each comprising:
    an emitter including a first semiconductor material,
    a base including a second semiconductor material having a band gap narrower than that of the first semiconductor material, the base defining a pn junction with the emitter, and
    a collector including one of the first semiconductor material and the second semiconductor material, the collector defining a pn junction with the base,
    the first and second heterojunction bipolar transistors constituting a differential transistor pair; and
    third and fourth heterojunction bipolar transistors (Tr8, Tr9) each comprising an emitter, a collector and a base, the emitters of the third and fourth heterojunction bipolar transistors being respectively coupled to the collectors of the first and second heterojunction bipolar transistors, the bases of the third and fourth heterojunction bipolar transistors being coupled to each other;

    characterised in that there is provided voltage supplying means for supplying a fixed voltage ($V_A$) to the bases of the third and fourth heterojunction bipolar transistors (Tr8, Tr9), the fixed voltage ($V_A$) having a value such that a collector-emitter voltage ($V_{CE}$) of the first and second heterojunction bipolar transistors (Tr1, Tr2) has a value such that the cut-off frequency of the first and second heterojunction bipolar transistors (Tr1, Tr2) is at least 80% of the maximum cut-off frequency of the first and second heterojunction bipolar transistors.

2. The heterojunction bipolar transistor integrated circuit according to claim 1, wherein the voltage supplying means includes means for supplying the fixed voltage ($V_A$) having a value such that the cut-off frequency of the first and second heterojunction bipolar transistors (Tr1, Tr2) is the maximum cut-off frequency.

3. The heterojunction bipolar transistor integrated circuit according to claim 1, wherein the voltage supplying means includes means for supplying the fixed voltage to the bases of the first and second heterojunction bipolar transistors (Tr1, Tr2) so that the collector-emitter voltage ($V_{CE}$) of the heterojunction bipolar transistors (Tr1, Tr2) is in a range between 0.8 volts to 2.0 volts.

4. The heterojunction bipolar transistor integrated circuit according to claim 1, wherein the heterojunction bipolar transistors carry out a switching operation.

5. The heterojunction bipolar transistor integrated circuit according to claim 1, wherein the heterojunction bipolar transistors carry out an amplifying operation.

6. The heterojunction bipolar transistor integrated circuit according to claim 1, wherein the pair of heterojunction bipolar transistors operates as a differential amplifier of an ECL circuit.

7. The heterojunction bipolar transistor integrated circuit according to claim 3, wherein the first semiconductor material is AlGaAs, while the second semiconductor material is GaAs.

8. The heterojunction bipolar transistor integrated circuit according to claim 3, wherein the first and second semiconductor materials are selected from combinations of InGaAs and InP; Ge and GaAs; and Si and GaP.

9. The heterojunction bipolar transistor integrated circuit according to claim 1, wherein the third and fourth heterojunction bipolar transistors (Tr8, Tr9) have collectors connected to a power source through load resistors ($R_L$), respectively, and further comprising fifth and sixth transistors (Tr3, Tr4) each having a base connected to the collectors of the third and fourth heterojunction bipolar transistors, respectively, and being operable as emitter follower.

**Patentansprüche**

1. Integrierte Schaltung aus bipolaren Transistoren mit Heteroübergang, mit:

    einem ersten und einem zweiten bipolaren Transistor mit Heteroübergang (Tr1, Tr2), jeweils mit:
    einem Emitter, der ein erstes Halbleitermaterial aufweist;
    einer Basis, die ein zweites Halbleitermaterial mit einem Energiebandabstand, der kleiner ist als der des ersten Halbleitermaterials, wobei die Basis einen pn-Übergang mit dem Emitter bildet;
    einem Kollektor, der entweder das erste Halbleitermaterial oder das zweite Halbleitermaterial, aufweist, wobei der Kollektor einen pn-Übergang mit der Basis bildet:

wobei der erste und der zweite bipolare Transistor mit Heteroübergang ein Differenztransistorpaar bilden; und

einem dritten und einem vierten bipolaren Transistor mit Heteroübergang (Tr8, Tr9), jeweils mit einem Emitter, einem Kollektor und einer Basis, wobei die Emitter des dritten und des vierten bipolaren Transistor mit Heteroübergang jeweils mit den Kollektoren des ersten und des zweiten bipolaren Transistors mit Heteroübergang gekoppelt sind, wobei die Basen des dritten und des vierten bipolaren Transistors mit Heteroübergang miteinander gekoppelt sind;

dadurch gekennzeichnet, daß eine Spannungsliefereinrichtung bereitgestellt wird zum Liefern einer festen Spannung $(V_A)$ an die Basen des dritten und des vierten bipolaren Transistors mit Heteroübergang (Tr8, Tr9), wobei die feste Spannung $(V_A)$ einen solchen Wert hat, daß eine Kollektor-Emitter-Spannung $(V_{CE})$ des ersten und des zweiten bipolaren Transistors mit Heteroübergang (Tr1, Tr2) einen solchen Wert hat, daß die Grenzfrequenz des ersten und des zweiten bipolaren Transistors mit Heteroübergang (Tr1, Tr2) mindestens 80% der maximalen Grenzfrequenz des ersten und des zweiten bipolaren Transistors mit Heteroübergang beträgt.

2. Integrierte Schaltung aus bipolaren Transistoren mit Heteroübergang nach Anspruch 1, wobei die Spannungsliefereinrichtung eine Einrichtung zum Liefern der festen Spannung $(V_A)$ mit einem solchen Wert aufweist, daß die Grenzfrequenz des ersten und des zweiten bipolaren Transistors mit Heteroübergang (Tr1, Tr2) die maximale Grenzfrequenz ist.

3. Integrierte Schaltung aus bipolaren Transistoren mit Heteroübergang nach Anspruch 1, wobei die Spannungsliefereinrichtung eine Einrichtung aufweist zum Liefern der festen Spannung an die Basen des ersten und des zweiten bipolaren Transistors mit Heteroübergang (Tr1, Tr2), so daß die Kolektor-Emitter-Spannung $(V_{CE})$ der bipolaren Transistoren mit Heteroübergang (Tr1, Tr2) in einem Bereich zwischen 0,8 Volt und 2,0 Volt liegt.

4. Integrierte Schaltung aus bipolaren Transistoren mit Heteroübergang nach Anspruch 1, wobei die bipolaren Transistoren mit Heteroübergang einen Schaltbetrieb ausführen.

5. Integrierte Schaltung aus bipolaren Transistoren mit Heteroübergang nach Anspruch 1, wobei die bipolaren Transistoren mit Heteroübergang einen Verstärkungsbetrieb ausführen.

6. Integrierte Schaltung aus bipolaren Transistoren mit Heteroübergang nach Anspruch 1, wobei das bipolare Transistorpaar mit Heteroübergang wie ein Differentialverstärker einer emittergekoppelten Logikschaltung arbeitet.

7. Integrierte Schaltung aus bipolaren Transistoren mit Heteroübergang nach Anspruch 3, wobei das erste Halbleitermaterial AlGaAs ist, während das zweite Halbleitermaterial GaAs ist.

8. Integrierte Schaltung aus bipolaren Transistoren mit Heteroübergang nach Anspruch 3, wobei das erste und das zweite Halbleitermaterial aus Kombinationen aus InGaAs und InP; Ge und GaAs: und Si und GaP gewählt sind.

9. Integrierte Schaltung aus bipolaren Transistoren mit Heteroübergang nach Anspruch 1, wobei der dritte und der vierte bipolare Transistor mit Heteroübergang (Tr8, Tr9) Kollektoren haben, die jeweils mit der Stromquelle über Lastwiderstände $(R_L)$ verbunden sind, und ferner mit einem fünften und einem sechsten Transistor (Tr3, Tr4), die jeweils eine Basis haben, die mit den Kollektoren des dritten bzw. des vierten Transistors mit Heteroübergang verbunden sind und als Emitterfolger betriebsfähig sind.

## Revendications

1. Circuit intégré à transistors bipolaires à hétérojonction comprenant

des premier et second transistors bipolaires à hétérojonction (Tr1, Tr2) dont chacun comprend:

un émetteur incluant un premier matériau semiconducteur:

une base incluant un second matériau semiconducteur présentant une bande interdite plus étroite que celle du premier matériau semiconducteur, la base définissant une jonction PN avec l'émetteur ; et

un collecteur incluant l'un des premier et second matériaux semiconducteurs, le collecteur définissant une jonction PN avec la base;

les premier et second transistors bipolaires à hétérojonction constituant une paire de transistors différentielle; et

des troisième et quatrième transistors bipolaires à hétérojonction (Tr8, Tr9) dont chacun comprend un émetteur, un collecteur et une base, les émetteurs des troisième et quatrième transistors bipolaires à hétérojonction étant respectivement couplés aux collecteurs des premier et second transistors bipolaires à hétérojonction, les bases des troisième et quatrième transistors bipolaires à hétérojonction étant couplées l'une à l'autre,

caractérisé en ce qu'est prévu un moyen d'application de tension pour appliquer une tension fixe ($V_A$) sur les bases des troisième et quatrième transistors bipolaires à hétérojonction (Tr8, Tr9), la tension fixe ($V_A$) présentant une valeur qui est telle qu'une tension collecteur-émetteur ($V_{CE}$) des premier et second transistors bipolaires à hétérojonction (Tr1, Tr2) présente une valeur qui est telle que la fréquence de coupure des premier et second transistors bipolaires à hétérojonction (Tr1, Tr2) vaut au moins 80% de la fréquence de coupure maximum des premier et second transistors bipolaires à hétérojonction.

2. Circuit intégré à transistors bipolaires à hétérojonction selon la revendication 1, dans lequel le moyen d'application de tension inclut un moyen pour appliquer la tension fixe ($V_A$) présentant une valeur qui est telle que la fréquence de coupure des premier et second transistors bipolaires à hétérojonction (Tr1, Tr2) est la fréquence de coupure maximum.

3. Circuit intégré à transistors bipolaires à hétérojonction selon la revendication 1, dans lequel le moyen d'application de tension inclut un moyen pour appliquer la tension fixe sur les bases des premier et second transistors bipolaires à hétérojonction (Tr1, Tr2) de telle sorte que la tension collecteur-émetteur ($V_{CE}$) des transistors bipolaires à hétérojonction (Tr1, Tr2) soit dans une plage entre 0,8 volt et 2,0 volts.

4. Circuit intégré à transistors bipolaires à hétérojonction selon la revendication 1, dans lequel les transistors bipolaires à hétérojonction mettent en oeuvre une opération de commutation.

5. Circuit intégré à transistors bipolaires à hétérojonction selon la revendication 1, dans lequel les transistors bipolaires à hétérojonction mettent en oeuvre une opération d'amplification.

6. Circuit intégré à transistors bipolaires à hétérojonction selon la revendication 1, dans lequel la paire de transistors bipolaires à hétérojonction fonctionne en tant qu'amplificateur différentiel d'un circuit ECL.

7. Circuit intégré à transistors bipolaires à hétérojonction selon la revendication 3, dans lequel le premier matériau semiconducteur est de l'AlGaAs tandis que le second matériau semiconducteur est du GaAs.

8. Circuit intégré à transistors bipolaires à hétérojonction selon la revendication 3, dans lequel les premier et second matériaux semiconducteurs sont choisis parmi les combinaisons InGaAs et InP: Ge et GaAs; et Si et GaP.

9. Circuit intégré à transistors bipolaires à hétérojonction selon la revendication 1, dans lequel les troisième et quatrième transistors bipolaires à hétérojonction (Tr8, Tr9) comportent des collecteurs connectés à une source d'alimentation par l'intermédiaire respectivement de résistances de charge ($R_L$) et comprenant en outre des cinquième et sixième transistors (Tr3, Tr4) dont chacun comporte une base connectée respectivement aux collecteurs des troisième et quatrième transistors bipolaires à hétérojonction et pouvant fonctionner en tant que suiveur d'émetteur.

# FIG.1

# FIG.2

**FIG.3**

**FIG.6** *(PRIOR ART)*

9

FIG. 4 (a)

FIG. 4 (b)      FIG. 4 (c)

FIG.5(a)

FIG.5(b)